# EUROPEAN PATENT APPLICATION

(11) **EP 1 717 856 A2**
(43) Date of publication of application: **02.11.2006**
(21) Application number: 06008197.3
(22) Date of filing: 20.04.2006
(51) Int. Cl.: H01L 23/50

(54) **Processing device on which processing elements having same function are embedded in one chip**

(30) Priority: 28.04.2005 JP 2005133631
(71) Applicant: KABUSHIKI KAISHA TOSHIBA, Tokyo 105-8001 (JP)
(72) Inventor: Urakawa, Yukihiro, 1-1 Shibaura 1-chome Tokyo 105-8001 (JP)
(74) Representative: HOFFMANN EITLE

(57) **Abstract**

A processing device according to an embodiment of the invention comprises first and second processing elements (PE0, PE1) having the same function, first and second power lines (VDD, VSS) which are disconnected each other and which are provided on the first and second processing elements (PE0, PE1) respectively, and a power source terminal (12) which is provided on the first processing element (PE1) and which is connected to the first processing element (PE1) and the first power line (VDD, VSS), wherein a power source terminal is not provided on the second processing element (PE0).

## Description

The present invention relates to a processing device on which processing elements having the same function are embedded in one chip.

In a processing device such as a microprocessor, the attention has been drawn to a new technology for enhancing the processing capability by disposing plural processing elements having the same function in one chip, and operating these plural processing elements in parallel. According to this technology, an appropriate processing device can be provided in a short period depending on the type of the system by determining the number of processing elements at the time of designing.

In such a processing device, even if there is one defective processing element which does not operate normally in a chip, use of the defective block is prohibited, and only normally operating processing elements are functioned and the chip is approved as a conforming product, for the purpose of enhancing the yield of conforming products. This is known as logic redundancy technology.

In the logic redundancy technology, however, leak current of a defective block is a bottleneck for reduction of power consumption. That is, since supply voltage is applied to a defective block which is not practically used, the electric power consumed in the processing device is enormous if power short defect is occurring in the defective block.

In the field of semiconductor memory, on the other hand, a fuse element is connected between a power line and a memory block, and if the memory block is defective, the fuse element is cut off, so that supply voltage is not applied to the memory block, which is known as power isolation technology.

However, the power isolation technology is a technology effective in a circuit of small current consumption such as a semiconductor memory, and cannot be applied to a circuit of larger current consumption as compared with a semiconductor memory, such as a logic circuit including a processing device. This is because, when a fuse element is connected between a power line and a processing element, operation of the processing element is disturbed due to voltage drop of the fuse element (resistive element).

A processing device according to a first aspect of the invention comprises first and second processing elements having the same function, first and second power lines which are disconnected each other and which are provided on the first and second processing elements respectively, and a power source terminal which is provided on the first processing element and which is connected to the first processing element and the first power line, wherein a power source terminal is not provided on the second processing element.

A processing device according to a second aspect of the invention comprises first and second processing elements having the same function, first and second power lines which are disconnected each other and which are provided on the first and second processing elements respectively, and a package having a power source terminal, wherein the power source terminal is provided on the first processing element and which is connected to the first processing element and the first power line, wherein a power source terminal of the package is not provided on the second processing element.

A processing device according to a third aspect of the invention comprises first and second processing elements having the same function, first and second power lines which are disconnected each other and which are provided on the first and second processing elements respectively, and a package having a power source terminal and a power source plate commonly used among the first and second processing elements, wherein the power source terminal is provided on the first processing element and which is connected to the first processing element and the first power line, wherein a power source terminal of the package is not provided on the second processing element.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a view showing a processing device as an example of the invention;
FIG. 2 is a view showing an outline of the example of the invention;
FIG. 3 is a view showing a processing device according to a first embodiment of the invention;
FIG. 4 is a view showing the processing device according to the first embodiment;
FIG. 5 is a view showing a chip and package according to the first embodiment;
FIG. 6 is a view showing a structure of the chip according to the first embodiment;
FIG. 7 is a view showing a first modified example of the first embodiment;
FIG. 8 is a view showing a second modified example of the first embodiment;
FIG. 9 is a view showing a third modified example of the first embodiment;
FIG. 10 is a flow chart showing a method of manufacturing the processing device according to the first embodiment;
FIG. 11 is a view showing a processing device according to a second embodiment of the invention;
FIG. 12 is a view showing the processing device according to the second embodiment;
FIG. 13 is a view showing a chip and package according to the second embodiment;
FIG. 14 is a view showing a structure of the package according to the second embodiment;
FIG. 15 is a view showing a first modified example of the second embodiment;
FIG. 16 is a view showing a second modified example of the second embodiment;
FIG. 17 is a view showing a third modified example of the second embodiment;
FIG. 18 is a flow chart showing a method of manufacturing the processing device according to the second embodiment;
FIG. 19 is a view showing a chip and package according to a third embodiment of the invention;
FIG. 20 is a view showing a structure of the package according to the third embodiment;
FIG. 21 is a view showing a structure of the package according to the third embodiment;
FIG. 22 is a flow chart showing a method of manufacturing the processing device according to the third embodiment; and
FIG. 23 is a view showing an application example of the processing device of the example of the invention.

An aspect of the present invention will be described below in detail with reference to the accompanying drawing.

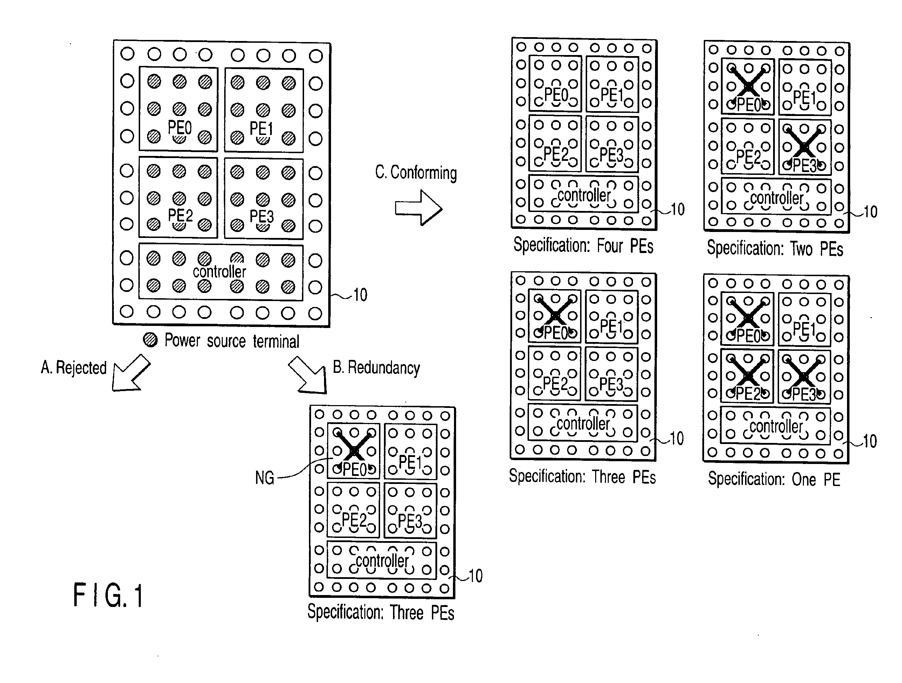

1. FIG. 1 shows a processing device as an aspect of the present invention.

A chip 10 houses a controller, and plural processing elements (processing elements) PE0, PE1, PE2, PE3 having the same function. The controller functions, for example, as a central processing unit (CPU), and the plural processing elements PE0, PE1, PE2, PE3 function, for example, as signal processors.

Herein, if at least one of the plural processing elements PE0, PE1, PE2, PE3 fails to operate normally, three measures are considered, that is, A. the chip 10 is rejected, B. saved by logic redundancy technology, and C. modified as a conforming product of different specification.

The logic redundancy technology of B is a technology of, in the case where specification is set to a processing device having three processing elements, disposing three processing elements and one or more redundancy block (processing element) in the chip 10, thereby saving the chip 10 as a conforming product even if a defective block NG occurs.

To modify as a conforming product in C is a technology of saving the chip 10 as a conforming product by changing the specification of the chip 10 depending on the number of normally operating processing elements even if a defective block NG occurs, unless all the processing elements are defective, and applying to an application suited to the specification.

An aspect of the present invention proposes a technology for completely preventing leak current in a defective block NG in a processing device saved by such logic redundancy technology or modification.

In the aspect of the present invention, accordingly, a new configuration is employed, in which part or all of routes for feeding supply voltage to plural processing elements are provided independently in each block, and the feeding route of supply voltage is cut off with respect to a defective block NG without adding a new element such as a fuse element. In this case, supply voltage is fed to normal processing elements, and supply voltage is not fed to defective blocks NG, so that leak current in the defective blocks NG can be prevented completely.

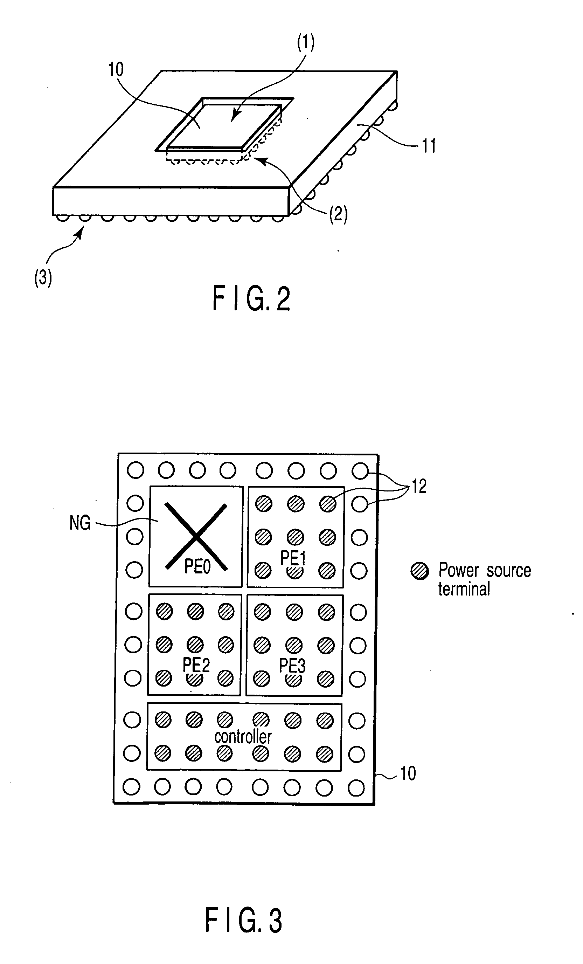

The position for cutting off the feeding route of supply voltage is any one of (1) a chip terminal (bump), (2) a chip side terminal (pad) of a package 11, and (3) a printed circuit board (PCB) side terminal (bump) of the package 11, as shown in FIG. 2. The structures of the chip 10 and package 11 change depending on the cutting position, and thus, the detail will be described in the following embodiments.

2. Some of the best modes of carrying out the invention will be described below.

### (1) First embodiment

A first embodiment of the invention relates to a processing device in which presence or absence of cutting of a feeding route of supply voltage is set in each processing element in chip terminals (bumps).

### A. Configuration

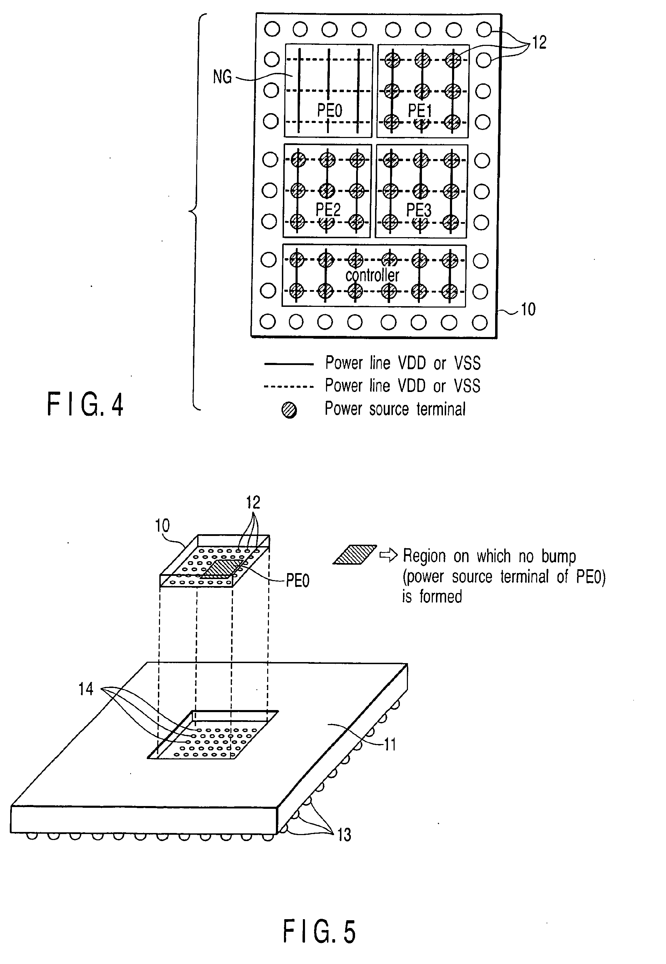

FIGS. 3 and 4 show the processing device according to the first embodiment.

A chip 10 houses a controller, and plural processing elements PE0, PE1, PE2, PE3 having the same function. As a result of an operation test, suppose the processing element PE0 is determined to be defective block NG out of the plural processing elements PE0, PE1, PE2, PE3.

Chip terminals (bumps) 12 are disposed on the chip 10. The chip terminals 12 disposed on the processing elements PE0, PE1, PE2, PE3 are power source terminals for feeding supply voltage (VDD or VSS), and are provided independently for each of the processing elements PE0, PE1, PE2, PE3.

However, as for the processing element PE0 determined to be a defective block NG, the chip terminal 12 is not disposed on the processing element PE0 in order to cut off feed of supply voltage to the processing element PE0.

The chip terminals 12 on the controller are power source terminals for feeding supply voltage to the controller 12, and chip terminals 12 provided on the edge of the chip 10 are input/output (I/O) terminals for use in input and output of data.

Even in the case where the chip terminal 12 is not disposed on the processing element PE0 which is a defective block NG, supply voltage is fed into the defective block NG if the power line is shared among circuit blocks including the controller and processing elements PE0, PE1, PE2, PE3 formed in the chip 10.

Accordingly, as shown in FIG. 4, a power line (VDD or VSS) is also provided independently in each circuit block disposed in the chip 10.

That is, the power line is closed within one circuit block, for example, within the processing element PE0. Therefore, supply voltage fed to one circuit block will never flow into other circuit blocks.

FIG. 5 shows a mode of mounting the chip of FIGS. 3 and 4 on the package.

On one side of the package 11, PCB side terminals (bumps) 13 are disposed in an array. On the other side of the package 11, a recess for mounting the chip 10 is provided, and chip side terminals (pads) 14 are disposed in an array in the recess corresponding to the chip terminals 12.

In the package 11, the chip side terminals 14 are disposed also in the positions corresponding to the processing element PE0. That is, as for the package 11, for example, a universal package can be used so that a power source plate is commonly used among all the processing elements PE0, PE1, PE2, PE3, and therefore, the manufacturing cost of the product can be lowered.

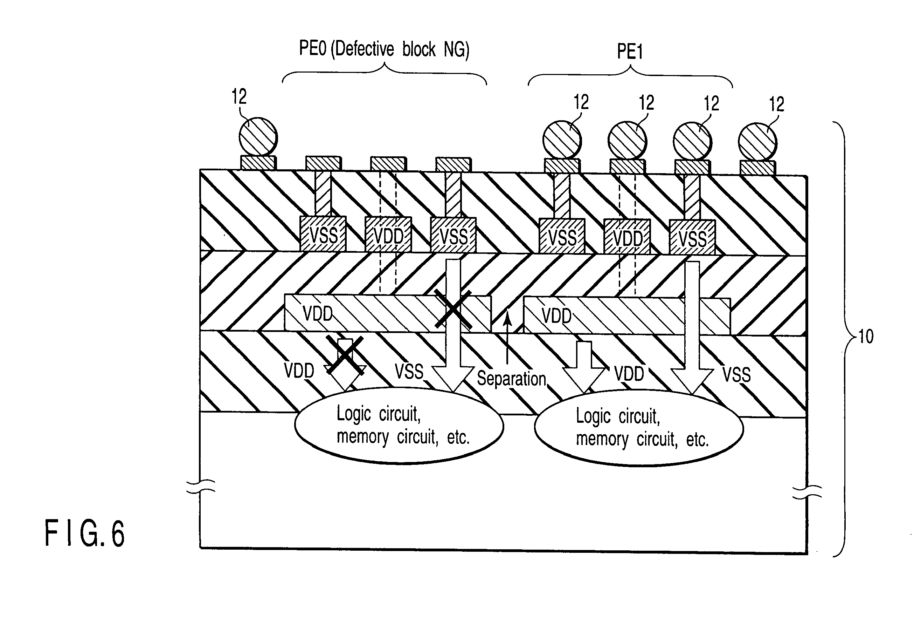

However, as shown in FIG. 6, since the chip terminal 12 is not disposed on the processing element PE0 which is a defective block NG at the chip 10 side, supply voltage will never be fed to the processing element PE0.

The package explained herein is merely an example, and the example of the invention is not limited to the type of the package, but can be applied in various forms of package.

According to this configuration, supply voltage to a defective block can be cut off only by independent connection of the power line and modification of layout of the chip terminals, so that leak current in a defective block can be prevented completely. Besides, since a fuse element is not used in cutting of supply voltage, there is no problem of malfunction of the circuit blocks due to voltage drop.

### B. Modified examples

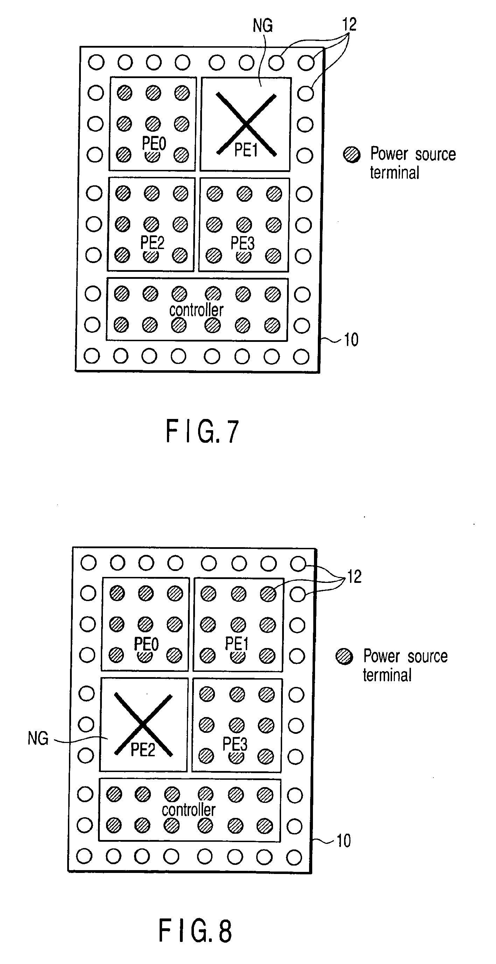

FIGS. 7 to 9 show modified examples of the chip of the first embodiment.

FIG. 7 shows a case in which the processing element PE1 is a defective block NG. In this case, chip terminal 12 is not disposed on the processing element PE1.

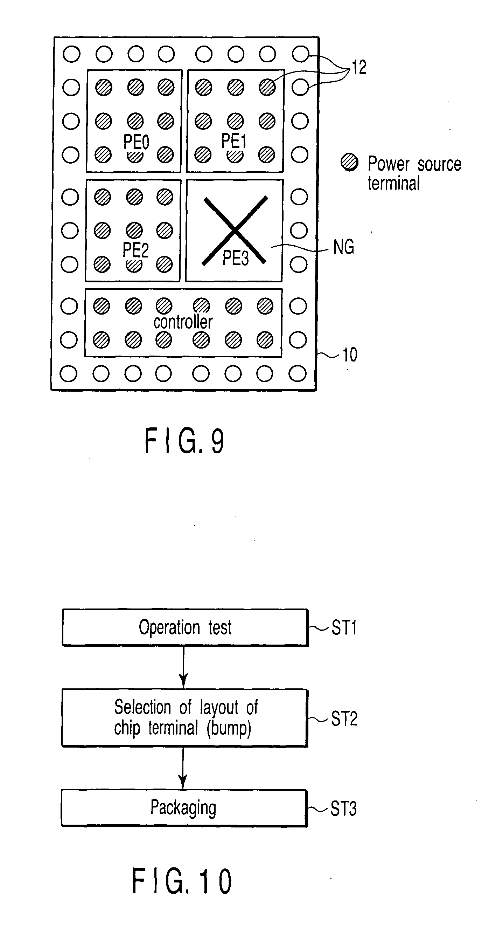

Similarly, as shown in FIGS. 8 and 9, when the processing elements PE2 and PE3 are defective blocks NG, the chip terminal 12 is not disposed on the processing elements PE2 and PE3.

Even if two or more of the processing elements PE0, PE1, PE2, PE3 are defective blocks NG, the same effects as in the first embodiment are obtained unless the chip terminal 12 is disposed on these defective blocks NG.

### C. Manufacturing method

FIG. 10 shows a method of manufacturing the processing device of the first embodiment.

First, after forming circuit blocks such as a controller and processing elements on the chip, the operation of these circuit blocks is tested. This operation test is intended to check the functions of the circuit blocks by bringing a tester probe into contact with the pads on the chip (step ST1).

Depending on results of the operation test, layout of chip terminals (bumps) is selected. For example, when the processing element PE0 is determined to be defective, a layout in which no chip terminal exists on the processing element PE0 is selected, and chip terminals are formed in this layout (step ST2).

Finally, by packaging for mounting the chip on the package, the processing device of the first embodiment is obtained (step ST3).

### D. Others

In the first embodiment, by cutting off supply voltage (VDD or VSS) to at least one of defective blocks, the purpose of preventing leak current is achieved. The first embodiment is also applicable in the case of using three or more supply voltages (VDD1, VDD2, ... VSS).

The first embodiment has an effect of preventing leak current in a defective block of a processing device having plural processing elements.

### (2) Second embodiment

A second embodiment of the invention relates to a processing device in which presence or absence of cutting of a feeding route of supply voltage is set in each processing element in chip terminals (bumps) of package.

### A. Configuration

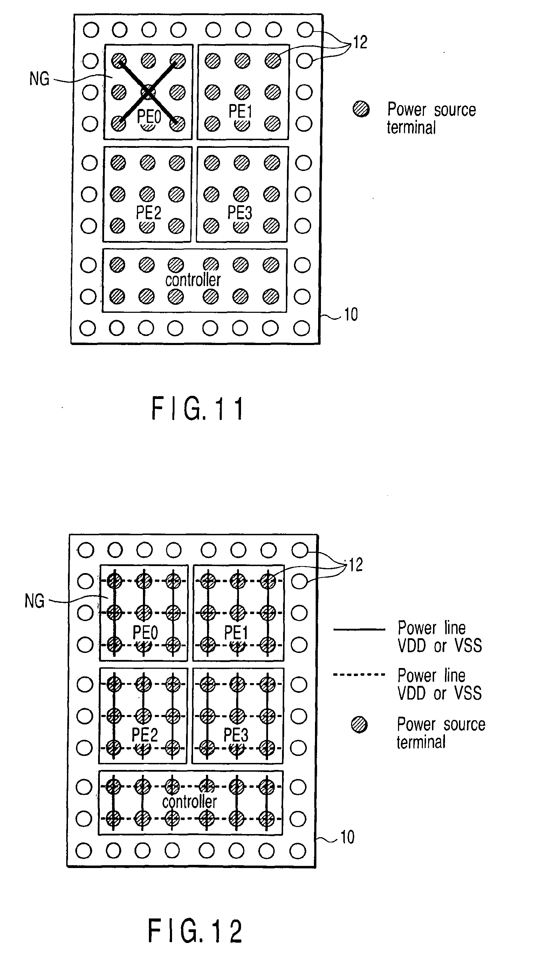

FIGS. 11 and 12 show the processing device according to the second embodiment.

A chip 10 houses a controller, and plural processing elements PE0, PE1, PE2, PE3 having the same function. In the same manner as in the first embodiment, suppose that, as a result of an operation test, the processing element PE0 is determined to be a defective block NG, out of the plural processing elements PE0, PE1, PE2, PE3.

Chip terminals (bumps) 12 are disposed on the chip 10. The chip terminals 12 disposed on the processing elements PE0, PE1, PE2, PE3 are power source terminals for feeding supply voltage (VDD or VSS), and are provided independently for each of the processing elements PE0, PE1, PE2, PE3.

In the second embodiment, however, the chip terminal 12 is also disposed on the processing element PE0 determined to be a defective block NG.

The chip terminals 12 on the controller are power source terminals for feeding supply voltage to the controller 12, and chip terminals 12 provided on the edge of the chip 10 are I/O terminals for use in input and output of data.

A power line (VDD or VSS) is provided independently in each circuit block disposed in the chip 10 in the same manner as in the first embodiment. That is, the power line is closed within one circuit block, for example, within the processing element PE0, and therefore, supply voltage fed to one circuit block will never flow into other circuit blocks.

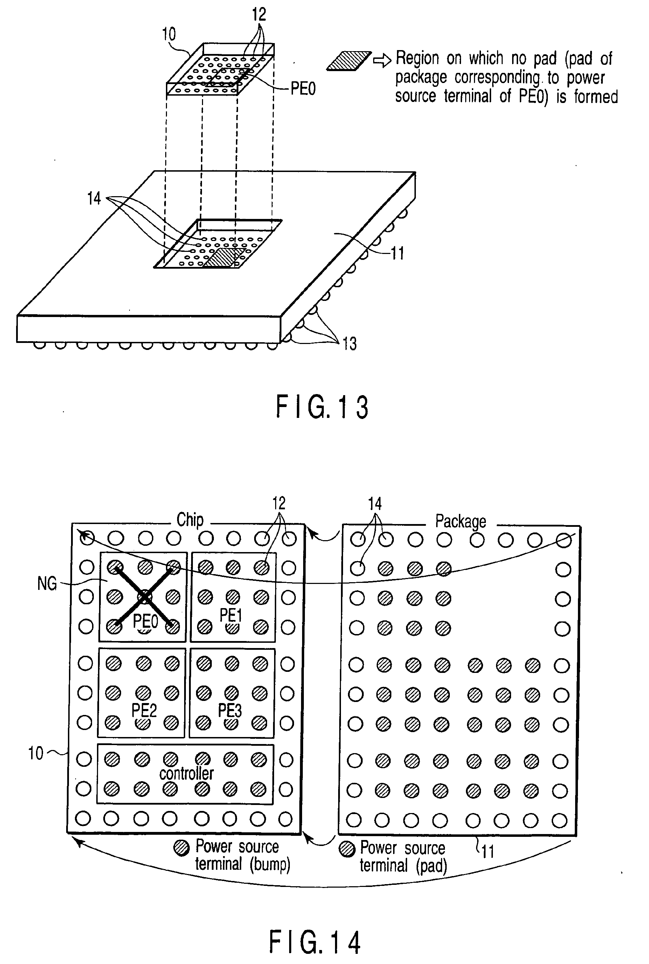

FIG. 13 shows a mode of mounting the chip of FIGS. 11 and 12 on the package.

On one side of the package 11, PCB side terminals (bumps) 13 are disposed in an array. On the other side of the package 11, a recess for mounting the chip 10 is provided, and chip side terminals (pads) 14 are in an array in the recess corresponding to the chip terminals 12.

However, as shown in FIG. 14, with respect to the package 11, the chip side terminal (power source terminal) 14 is not disposed in the portion corresponding to the processing element PE0 determined to be a defective block NG in order to cut off supply voltage to the processing element PE0.

Therefore, supply voltage will never be fed to the processing element PE0.

The package explained herein is merely an example, and the example of the invention is not limited to the type of the package, but can be applied in various forms of package.

According to this configuration, supply voltage to a defective block can be cut off only by independent connection of the power line and modification of layout of the chip side terminals, so that leak current in the defective block can be prevented completely. Besides, since a fuse element is not used in cutting of supply voltage, there is no problem of malfunction of the circuit blocks due to voltage drop.

Further, since selection of layout of a chip electrode is not needed, the chip manufacturing process can be simplified and unified.

### B. Modified examples

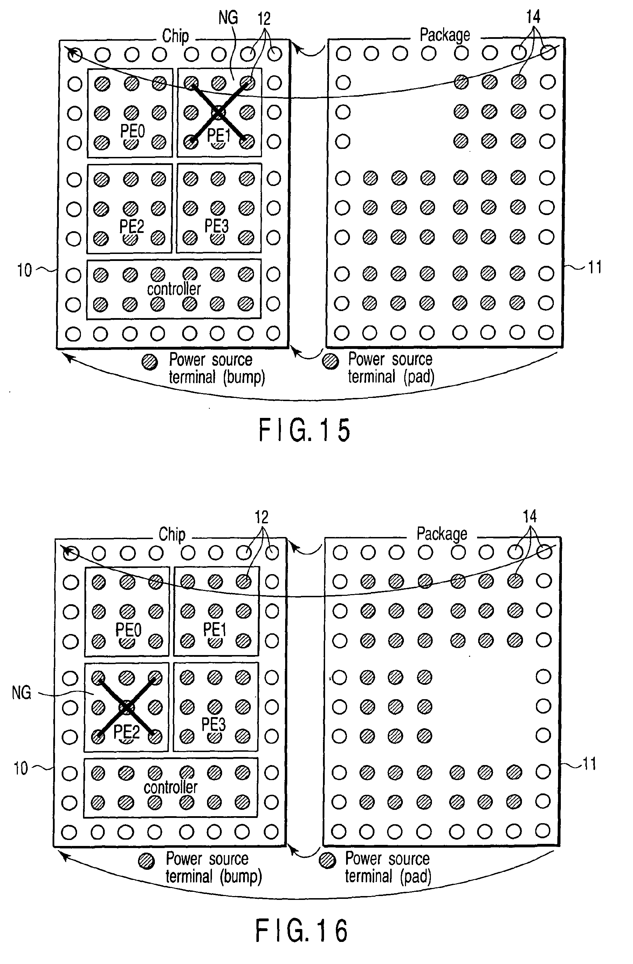

FIGS. 15 to 17 show modified examples of the chip of the second embodiment.

FIG. 15 shows a case in which the processing element PE1 is a defective block NG. In this case, the chip side terminal (power source terminal) 14 is not disposed in the portion corresponding to the processing element PE1.

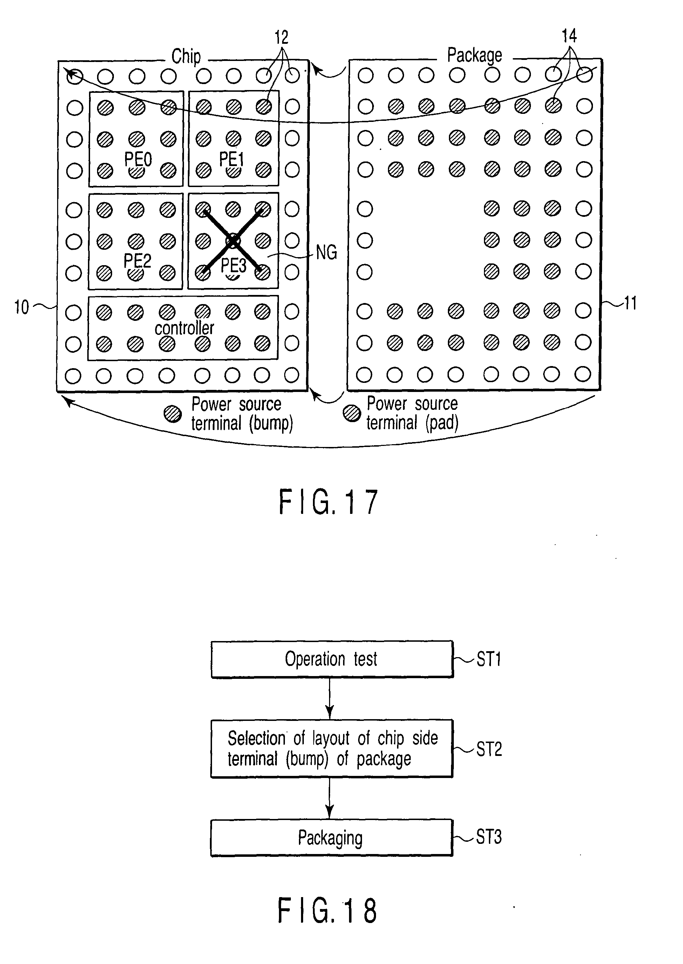

Similarly, as shown in FIGS. 16 and 17, when.the processing elements PE2 and PE3 are defective blocks NG, the chip side terminal (power source terminal) 14 is not disposed in the positions corresponding to the processing elements PE2 and PE3.

The same effects as in the second embodiment are obtained, when two or more of the processing elements PE0, PE1, PE2, PE3 are defective blocks NG and a power source terminal 14 is not disposed on the defective blocks NG.

### C. Manufacturing method

FIG. 18 shows a method of manufacturing the processing device according to the second embodiment.

First, after forming circuit blocks such as a controller and processing elements on the chip, and also forming chip terminals (bumps), the operation of these circuit blocks is tested. This operation test is intended to check the functions of the circuit blocks by bringing a tester probe into contact with the chip terminals (step ST1).

Depending on results of the operation test, layout of chip side terminals (bumps) of the package is selected. For example, when the processing element PE0 is determined to be defective, a layout in which no chip side terminal is disposed on the portion corresponding to the processing element PE0 is selected (step ST2).

Finally, by packaging for mounting the chip on the selected package, the processing device of the second embodiment is obtained (step ST3).

### D. Others

Also in the second embodiment, by cutting off supply voltage (VDD or VSS) to at least one of defective blocks, the purpose of preventing leak current is achieved. The second embodiment is also applicable in the case of using three or more supply voltages (VDD1, VDD2, ..., VSS).

The second embodiment has an effect of preventing leak current in a defective block of a processing device having plural processing elements.

### (3) Third embodiment

A third embodiment of the invention relates to a processing device in which presence or absence of cutting of a feeding route of supply voltage is set in each processing element in PCB side terminals (bumps) of package.

### A. Configuration

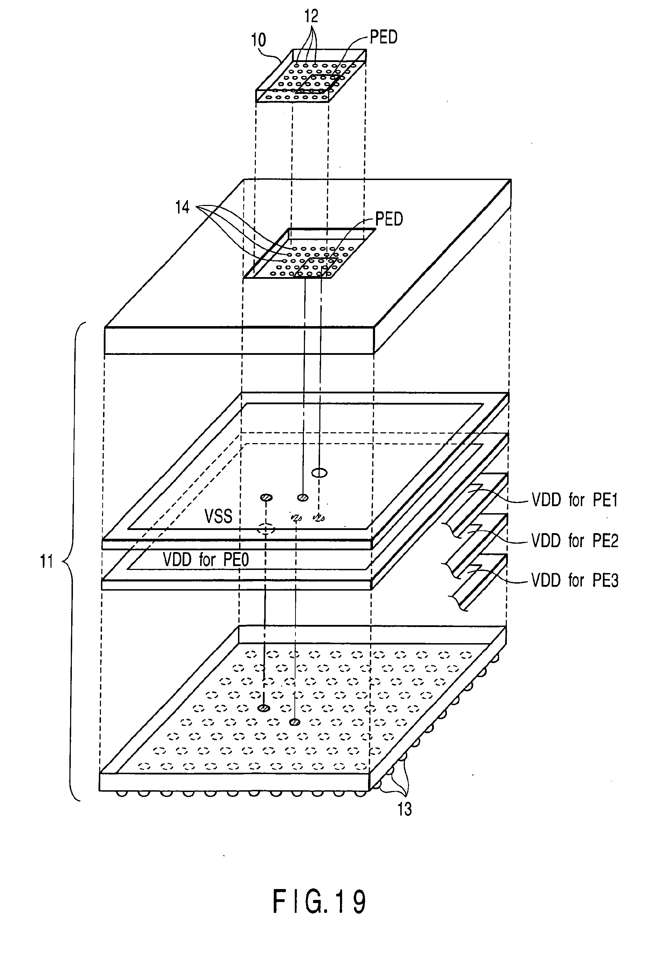

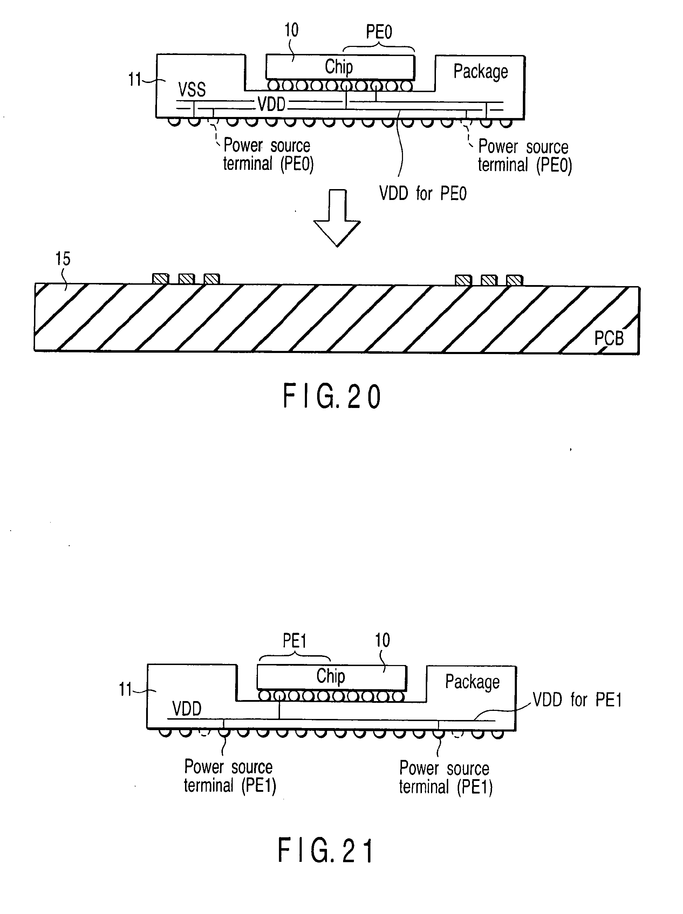

FIGS. 19 to 21 show the processing device according to the third embodiment.

The structure of a chip 10 is same as in the second embodiment.

That is, as shown in FIGS. 11 and 12, the chip 10 houses a controller, and plural processing elements PE0, PE1, PE2, PE3 having the same function. Power lines in the chip 10 are independent in each circuit block.

On one side of the package 11, PCB side terminals (bumps) 13 are disposed in an array. On the other side of the package 11, a recess for mounting the chip 10 is provided, and chip side terminals (pads) 14 are disposed in an array in the recess corresponding to the chip terminals 12.

In the third embodiment, the package 11 incorporates plural independent power source plates VDD for PE0, VDD for PE1, VDD for PE2, and VDD for PE3 corresponding to the plural processing elements PE0, PE1, PE2, and PE3.

In the power source plate VDD for PE0 corresponding to the processing element PE0 determined to be a defective block NG, the PCB side terminal (bump) 13 of the package 11 is not connected in order to cut off feed of supply voltage to the processing element PE0.

Therefore, supply voltage will never be fed to the processing element PE0.

The package explained herein is only an example, and the example of the invention is not limited to the type of the package, but can be applied in various forms of package.

According to this configuration, supply voltage to a defective block can be cut off only by independent connection of the power line and modification of layout of the PCB side terminals, so that leak current in the defective block can be prevented completely. Besides, since a fuse element is not used in cutting of supply voltage, there is no problem of malfunction of the circuit blocks due to voltage drop.

Further, since selection of layout of a chip electrode is not needed, the chip manufacturing process can be simplified and unified.

### B. Manufacturing method

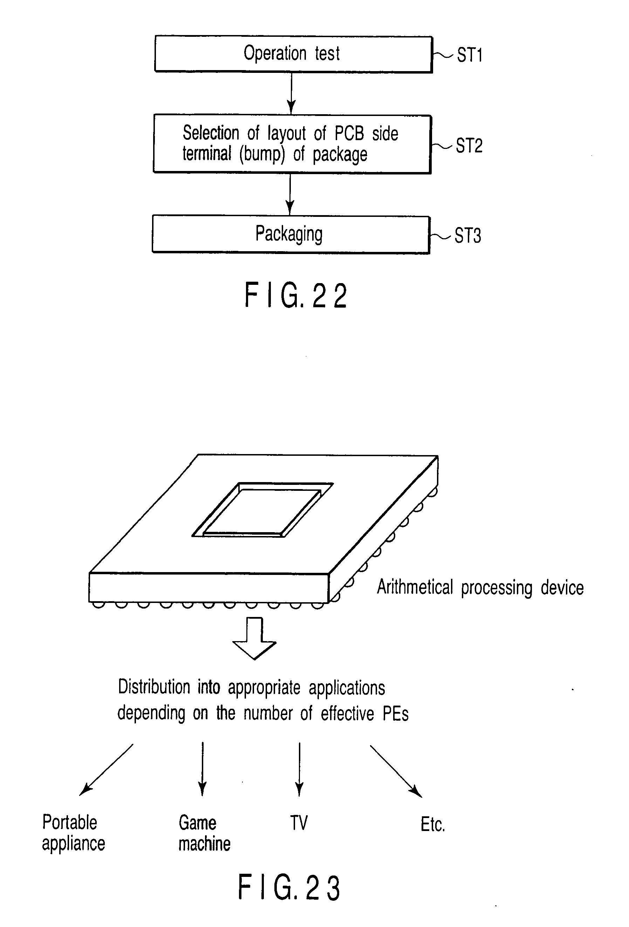

FIG. 22 shows a method of manufacturing the processing device according to the third embodiment.

First, after forming circuit blocks such as a controller and processing elements on the chip, and also forming chip terminals (bumps), the operation of these circuit blocks is tested. This operation test is intended to check the functions of the circuit blocks by bringing a tester probe into contact with the chip terminals (step ST1).

Depending on results of the operation test, layout of the PCB side terminals (bumps) of the package is selected. For example, when the processing element PE0 is determined to be defective, a layout in which no PCB side terminal is connected to the power source plate corresponding to the processing element PE0 is selected (step ST2).

Finally, by packaging for mounting the chip on the selected package, the processing device of the third embodiment is obtained (step ST3).

### C. Others

In the third embodiment, in the same manner as in the first and second embodiments, it is applicable to a case in which one of the processing elements PE1, PE2, and PE3 is defective, or to a case in which two or more of the processing elements PE0, PE1, PE2, and PE3 are defective.

Also in the third embodiment, by cutting off supply voltage (VDD or VSS) to at least one of defective blocks, the purpose of preventing leak current is achieved. The third embodiment is also applicable in the case of using three or more supply voltages (VDD1, VDD2, ... VSS).

The third embodiment has an effect of preventing leak current in a defective block of a processing device having plural processing elements.

3. The examples of the invention can be applied in processing devices such as a microprocessor, a graphic processor, a digital signal processor, and a microcomputer.

The processing device according to the examples of the invention can be used in various applications depending on the number of effective processing elements as shown in FIG. 23, for example, a portable appliance, a game machine, and TV.

4. The examples of the invention have effects of preventing leak current in a defective block of a processing device having plural processing elements.

With respect to the examples of the invention, plural processing elements may be those having the same function, and in addition thereto, may be duplicate blocks identical in layout.

Duplicate block may be one of a core processor of a multicore processor, and a shader processor of a graphic processor.

## Claims

1. A processing device **characterized by** comprising:
first and second processing elements (PE0, PE1, PE2, PE3) having the same function;
first and second power lines (VDD, VSS) which are disconnected each other and which are provided on the first and second processing elements respectively; and
a power source terminal (12) which is provided on the first processing element and which is connected to the first processing element and the first power line,
wherein a power source terminal is not provided on the second processing element.

2. The processing device according to claim 1, **characterized in that** each of the first and second processing elements (PE0, PE1, PE2, PE3) functions as a signal processor.

3. The processing device according to claim 1, **characterized in that** the power source terminal (12) is a bump.

4. The processing device according to claim 1, **characterized by** further comprising:
a power source plate (VDD, VSS) commonly used among the first and second processing elements.

5. A processing device **characterized by** comprising:
first and second processing elements (PEO, PE1, PE2, PE3) having the same function;
first and second power lines (VDD, VSS) which are disconnected each other and which are provided on the first and second processing elements respectively; and
a package (11) having a power source terminal (14),
wherein the power source terminal (14) is provided on the first processing element and which is connected to the first processing element and the first power line,
wherein a power source terminal of the package is not provided on the second processing element.

6. The processing device according to claim 5, **characterized in that** each of the first and second processing elements (PE0, PE1, PE2, PE3) functions as a signal processor.

7. The processing device according to claim 5, **characterized in that** the power source terminals (14) is a bump.

8. The processing device according to claim 5, **characterized in that** the package (11) has a power source plate (VDD, VSS) commonly used among the first and second processing elements.

9. A processing device **characterized by** comprising:
first and second processing elements (PEO, PE1, PE2, PE3) having the same function;
first and second power lines (VDD, VSS) which are disconnected each other and which are provided on the first and second processing elements respectively; and
a package (11) having a power source terminal (14) and a power source plate (VDD, VSS) commonly used among the first and second processing elements,
wherein the power source terminal (14) is provided on the first processing element and which is connected to the first processing element and the first power line,
wherein a power source terminal of the package is not provided on the second processing element.

10. The processing device according to claim 9, **characterized in that** each of the first and second processing elements (PE0, PE1, PE2, PE3) functions as a signal processor.

11. The processing device according to claim 9, **characterized in that** the power source terminal (14) is a bump.

12. The processing device according to claim 9, **characterized in that** the power source plate (VDD, VSS) comprises plural layers.

13. A method of manufacturing a processing device, **characterized by** comprising:
performing an operation test for a chip region having processing elements (PEO, PE1, PE2, PE3) having the same function and a power line (VDD, VSS) provided independently in each of the processing elements;
forming power source terminals (12) provided independently on processing elements except for a processing element determined not to operate normally out of the processing elements, on the processing elements except for the processing element determined not to operate normally; and
packaging.

14. The method according to claim 13, **characterized in that** the operation test determines to be conforming when at least one processing element (PE0, PE1, PE2, PE3) which operates normally exists among the processing elements.

15. The method according to claim 13, **characterized in that**, after the packaging, an application is decided on the basis of the number of processing elements (PEO, PE1, PE2, PE3) which operate normally out of the processing elements.

16. A method of manufacturing a processing device, **characterized by** comprising:
performing an operation test for a chip region (10) having processing elements (PE0, PE1, PE2, PE3) having the same function and a power line (VDD, VSS) provided independently in each of the processing elements;
forming a package (11) having chip side terminals (14) corresponding to power source terminals (VDD, VSS) of processing elements except for a processing element determined not to operate normally out of the processing elements; and
packaging.

17. The method according to claim 16, **characterized in that** the operation test determines to be conforming when at least one processing element (PEO, PE1, PE2, PE3) which operates normally exists among the processing elements.

18. The method according to claim 16, **characterized in that**, after the packaging, an application is decided on the basis of the number of processing elements (PEO, PE1, PE2, PE3) which operate normally out of the processing elements.

19. A method of manufacturing a processing device, **characterized by** comprising:
performing an operation test for a chip region (10) having processing elements (PE0, PE1, PE2, PE3) having the same function and a power line (VDD, VSS) provided independently in each of the processing elements;
forming a package (11) having power source plates (VDD, VSS) connected independently to the processing elements individually, and PCB side terminals (13) connected to power source plates (VDD, VSS) connected to processing elements except for a processing element determined not to operate normally out of the processing elements; and
packaging.

20. The method according to claim 19, **characterized in that** the operation test determines to be conforming when at least one processing element (PEO, PE1, PE2, PE3) which operates normally exists among the processing elements.

21. The method according to claim 19, **characterized in that**, after the packaging, an application is decided on the basis of the number of processing elements (PEO, PE1, PE2, PE3) which operate normally out of the processing elements.
